# EUROPEAN PATENT APPLICATION

(11) **EP 4 827 274 A2**
(43) Date of publication of application: **21.10.2026**
(21) Application number: 26195341.8
(22) Date of filing: 22.11.2018
(51) Int. Cl.: H10D 62/85

(54) **VERTICAL GAN TRANSISTOR WITH INSULATING CHANNEL AND THE METHOD OF FORMING THE SAME**

(30) Priority: 24.11.2017 SK 500742017
(62) Document number(s) of the earlier application(s) in accordance with Art. 76 EPC: 18830014.9 / 3 714 489
(71) Applicant: Elektrotechnicky Ústav Sav, 841 04 Bratislava (SK)
(72) Inventor: KUZMÍK, Ján, 811 05 Bratislava (SK)
(74) Representative: Porubcan, Róbert

(57) **Abstract**

The invention relates to a vertical GaN transistor with an insulating channel layer and to a method of forming the same. The transistor comprises a conductive GaN substrate, a drift n GaN layer, a channel insulating GaN layer and a contacting *n*⁺ GaN layer. Residual donors in the channel insulating GaN layer are compensated by adding carbon or increasing its concentration, wherein the concentration of carbon impurities is in the range of 10¹⁶ cm⁻³ to 10¹⁸ cm⁻³. A source electrode is located on the contacting *n*⁺ GaN layer, a drain electrode is located on the backside of the conductive GaN substrate, and a gate electrode is located vertically along the channel insulating GaN layer. The gate electrode is separated from the adjacent layers by a dielectric insulating layer having a wider energy band gap than GaN. The concentration of free electrons in the channel insulating GaN layer may be at most 10¹¹ cm⁻³. The source electrode may have a rectangular geometry with side lengths *w* and *r*. The invention also encompasses a method of sequentially forming the layers and electrodes.

## Description

### Field of the invention

The invention relates to vertical GaN transistors with an insulating channel and to methods of forming the same. In particular, it relates to the manufacture of power and high-frequency transistors having a positive threshold voltage.

### Background art

Securing ecological development of society is directly related to the creation of new methods for effective utilisation of available energy sources. One option is the minimisation of losses in electrical power converters. In order to maximise power and minimise conversion losses, the use of semiconductor GaN-based power transistors is highly appropriate.

GaN is a chemically inert material with an energy band gap of 3.4 eV, which makes it suitable for applications in hostile environments and at elevated temperatures above 300 °C. In addition, a high saturation drift velocity of electrons in GaN of about 1 × 10⁵ m/s enables transistor switching at high frequency. These material parameters are particularly suitable for constructing high-power and high-frequency transistors and converters with high efficiency.

Generally available GaN-based transistors are prepared as planar unipolar field-effect transistors (FETs). Charge transport takes place between the source and drain electrodes through the GaN channel and is controlled by the gate. The basis is an epitaxial structure grown mostly on a foreign substrate, such as silicon, sapphire or silicon carbide, or on a GaN substrate. A standard structure comprises the substrate, a buffer insulating (SI) GaN layer, a channel n GaN layer and a barrier AlGaN layer. Metal-organic chemical vapour deposition (MOCVD) or molecular-beam epitaxy (MBE) are commonly used as growth techniques. A channel n GaN layer should contain a minimum of dislocations and impurities, such as vacancies or carbon, in order to attain high charge-carrier mobility and favourable switching conditions while avoiding parasitic effects of deep levels.

In the case of MOCVD, however, carbon is present in growth precursors such as trimethylgallium (TMGa), and the growth conditions for the channel are therefore normally set so that the inherent carbon content is minimised. Standard growth conditions likewise cannot exclude residual donor impurities such as oxygen, and the concentration of free electrons in unintentionally doped GaN is typically in the range of 10¹⁶ cm⁻³. The channel n GaN layer is grown on a buffer insulating GaN layer, which provides favourable growth conditions by separating it from a defective GaN/substrate interface. The buffer layer typically has a thickness of about 1 to 5 µm.

The buffer insulating GaN layer also serves as an insulating layer providing a high resistance of the transistor in the off-state and a high breakdown voltage. Consequently, in contrast to the channel n GaN layer, the buffer GaN layer requires an intentionally increased concentration or additional introduction of deep acceptor states, such as carbon, iron, magnesium or gallium vacancies, which compensate residual donors. Such an insulating GaN layer is sometimes referred to as semi-insulating (SI). For example, the carbon content in a buffer insulating GaN layer grown by MOCVD can be controlled by a specific setting of growth temperature, pressure or gas flows.

The channel n GaN layer is normally covered by an AlGaN barrier layer having a thickness of about 20 to 50 nm, which forms a two-dimensional electron gas (2DEG) at the interface with n GaN. This provides channel conduction without degrading mobility through scattering at ionised impurities. To prevent injection of electrons from the 2DEG and parasitic trapping in deep levels of the buffer insulating GaN layer, the channel n GaN layer must have a sufficient thickness, for example about 100 nm. Electron injection from the channel n GaN layer and trapping in the buffer insulating GaN layer occurs mainly in the region of highest electric-field intensity, namely the longitudinal region of the buffer insulating GaN layer between the gate and drain electrodes. Electron trapping can cause undesirable depletion of the channel n GaN layer along the entire region owing to the electrostatic influence of trapped charge. The channel current consequently drops, an effect referred to as current collapse, and transistor switching is delayed. The composition and doping of the GaN heterostructure are therefore crucial to device performance.

Plasma etching is used in device preparation. Contact systems are evaporated through a mask prepared by photolithography and patterned by a lift-off technique. The gate electrode is generally isolated from the semiconductor by an oxide or dielectric insulating layer in a metal-oxide-semiconductor (MOS) or metal-insulator-semiconductor (MIS) structure. The distance between the gate and drain electrodes is selected to be sufficiently long, for example 10 µm, to provide the required transistor breakdown strength.

In addition to electron trapping in the buffer insulating GaN layer, common problems of planar GaN transistors include analogous electron trapping at surface states, a breakdown voltage lower than its theoretical value owing to the device geometry and surface-state properties, and enhanced self-heating caused by limited heat dissipation from the device surface. For these reasons, vertical transistors have been proposed as an alternative for GaN power devices.

A vertical transistor is characterised by charge transport in the vertical direction and by a GaN structure typically grown on a GaN substrate. The dislocation density in the epitaxial structure can be reduced because growth can be performed without strain at the substrate interface. The device surface area can also be reduced because the drain electrode is located on the side of the substrate opposite to the source electrode. This arrangement can reduce current collapse, increase breakdown voltage and improve heat dissipation. According to M. Sun et al., IEEE Electron Device Letters 38 (2017), 509, a unipolar vertical transistor made of n-type semiconductors begins with a highly doped contacting *n*⁺ GaN layer, followed by a drift n GaN layer having a donor concentration of about 10¹⁶ cm⁻³ and a thickness of several micrometres defining the breakdown voltage, a channel n GaN layer having a similar donor concentration defining the threshold voltage, and a highly doped source *n*⁺ GaN layer. Reference may also be made to US 2015/0179772 A1 and US 2016/0308045 A1.

The threshold voltage *V_{T}* of a transistor is the value of the voltage applied to the gate electrode at which the channel changes state between open and closed as a consequence of the electrostatic influence of the gate. When *V_{T}* > 0 V for a channel formed by free electrons, the device is an enhancement-mode transistor, which is closed without voltage being applied to the gate electrode. This type of transistor is particularly suitable for power converters. In the opposite case, the device is a depletion-mode transistor. The higher the density of donor impurities in the channel, the more negative the value of *V_{T}*. To obtain enhancement-mode operation, it is therefore necessary, for example, to reduce the concentration of donors, exclude their presence and/or reduce the thickness of the depletion region in the channel. An analogous situation applies to a channel formed by free holes.

The semiconductor type is determined by the position of impurity atoms in the energy-band structure of the semiconductor (S. M. Sze and K. K. Ng, Physics of Semiconductor Devices, Third Edition, Wiley, 2007). If the impurity energy level is close to the conduction band *E_{C}*, ionisation provides free electrons, the Fermi level *E_{F}* moves towards the conduction band, and the semiconductor is n-type. If the impurity energy level is close to the valence band *E_{V}*, ionisation generates free holes, *E_{F}* is close to *E_{V}*, and the semiconductor is p-type. The concentration of free charge carriers increases with impurity concentration and depends on the impurity energy level and ambient temperature.

For an undoped semiconductor, *E_{F}* is located approximately in the middle of the energy gap and free carriers are generated by charge exchange between the valence and conduction bands. This intrinsic concentration is significantly lower than in doped semiconductors. In particular for wide-band-gap semiconductors, an undoped semiconductor therefore behaves as an insulator. Insulating properties and localisation of *E_{F}* near the middle of the energy gap may also be obtained for a specific ratio of donor concentration *N_{D}* to acceptor concentration *N_{A}*. Charge exchange between ionised impurity levels then dominates, free-carrier generation is substantially reduced, and impurities and defects compensate one another so that the semiconductor is neither n-type nor p-type. Such a semiconductor is an insulator and is sometimes referred to as semi-insulating.

In GaN, residual donors, for example oxygen, may be compensated by carbon impurities generating acceptor levels. The carbon energy level is about 0.9 eV above the GaN valence band and is associated with a long charge-emission time constant and parasitic effects such as current collapse and delayed switching. The acceptor-to-donor concentration ratio *N_{A}*/*N_{D}* determines the compensation ratio. In order to maximise the elimination of free charges, the positions and charges of the acceptor and donor levels must be taken into account. For compensation of GaN by carbon, *N_{A}*/*N_{D}* > 1 generally applies, and a high carbon concentration is therefore used for growth of semi-insulating GaN. Unipolar devices use either electrons or holes for charge transport. Use of only one semiconductor type simplifies the design and preparation of GaN transistors.

State-of-the-art enhancement-mode unipolar vertical GaN transistors have the following drawbacks and limitations. The vertical transistors described by M. Sun et al., IEEE Electron Device Letters 38 (2017), 509, US 2015/0179772 A1 and US 2016/0308045 A1 have defined n-type or p-type channel conduction and an impurity concentration of at least 10¹³ cm⁻³. To obtain enhancement-mode operation, it is necessary to reduce the thickness of the depleted channel region to at most 10 µm and in practice to sub-micrometre dimensions. This requires complex steps such as nanopatterning and electron-beam lithography. To obtain higher currents, several vertical channels are connected in parallel and their individual source electrodes are interconnected, requiring difficult technological steps such as self-aligned contacts and airbridge connections.

### Disclosure of the invention

The invention is defined in claims 1 to 6. The drawbacks of the prior art are addressed by a unipolar vertical GaN transistor having an insulating GaN channel and a positive threshold voltage. The enhancement-mode transistor is grown on a conductive GaN substrate and comprises, from the bottom, a drift n GaN layer, a channel insulating GaN layer and a highly doped contacting *n*⁺ GaN layer. The insulating properties of the channel insulating GaN layer are provided by compensating residual donors through the intentional addition or increase of deep acceptor impurities or defects.

The vertical GaN transistor comprises, from the bottom, at least: (a) a conductive GaN substrate; (b) a drift n GaN layer; (c) a channel insulating GaN layer in which residual donors are compensated by impurities or defects; and (d) a contacting *n*⁺ GaN layer. A source electrode is located on the top of the contacting *n*⁺ GaN layer, a drain electrode is located on the backside of the GaN substrate, and a gate electrode is located vertically along the channel insulating GaN layer and is separated from the GaN semiconductor by a dielectric insulating layer having a wider energy band gap than GaN.

Residual donors in the channel insulating GaN layer may be compensated by carbon (C), iron (Fe), magnesium (Mg), or gallium (Ga) vacancies. According to a further aspect, the concentration of free electrons in the channel insulating GaN layer is less than or equal to 1 × 10¹¹ cm⁻³.

The invention also concerns a method of forming the vertical GaN transistor on a conductive GaN substrate. The method comprises at least growing a drift n GaN layer, growing a channel insulating GaN layer in which residual donors are compensated by impurities or defects, and growing a contacting *n*⁺ GaN layer. A source electrode is formed on the contacting *n*⁺ GaN layer, a drain electrode is formed on the backside of the GaN substrate, and a gate electrode is formed vertically along the channel insulating GaN layer and separated from the GaN semiconductor by a dielectric insulating layer having a wider energy band gap than GaN.

According to further embodiments, residual donors in the channel insulating GaN layer are compensated by carbon impurities, iron impurities or magnesium impurities.

According to a further aspect, the concentration of free electrons in the channel insulating GaN layer is less than or equal to 1 × 10¹¹ cm⁻³.

The source electrode is located on top of the contacting *n*⁺ GaN layer, and the drain electrode is provided on the backside of the substrate. The gate electrode is formed vertically along the channel insulating GaN layer and is separated from the GaN semiconductor by a dielectric insulating layer having a wider energy band gap than GaN. The insulating character of the channel GaN layer ensures enhancement-mode operation of the transistor and also enables a robust transistor construction without the need for nano-patterning, a parallel combination of several channels, or airbridge interconnection of the source electrodes.

The use of a channel insulating GaN layer may appear counterproductive and has never previously been used in GaN transistors, because deep acceptor levels degrade electron mobility and cause electron trapping, leading to parasitic phenomena such as current collapse and delayed switching. However, in the proposed vertical transistor, unlike in planar transistors, the region between the channel insulating GaN layer and the drain electrode is formed exclusively from n-type semiconductor, which significantly reduces the possibility of electron trapping. Furthermore, in the on-state, the direct connection of the channel insulating GaN layer to the drift n GaN layer causes effective extraction of electrons from the channel insulating GaN layer by the perpendicular electric field. High electron mobility can generally be expected in layers grown on a GaN substrate and may be partially degraded only if the concentration of compensating levels is increased. For the current density of a short-channel transistor, however, the decisive parameter is the electron saturation velocity, which is a material parameter of GaN only partly related to electron mobility.

### Brief description of the drawings

Figure 1 shows a schematic cross-section of an enhancement-mode vertical GaN transistor having a channel insulating GaN layer.
Figure 2 shows the setting of the distance between vertical walls of the channel insulating GaN layer by reactive ion etching (RIE) of a mesa region.
Figure 3 shows formation of the source electrode by optical lithography after RIE.
Figure 4 shows formation of the resist mask for the gate electrode.
Figure 5 shows a top view of the source electrode having a circular geometry and a lead-out of the contact pad of the gate electrode.
Figure 6 shows calculated output characteristics of the vertical GaN transistor of Figure 1 with a channel width of 400 µm.
Figure 7 shows the energy-band diagram in the channel insulating GaN layer as a function of distance from the surface of the dielectric insulating layer for different concentrations of free electrons.
Figure 8 shows the energy-band diagram and concentration of free electrons in the channel insulating GaN layer as a function of distance from the surface of the dielectric insulating layer for different gate-electrode biases.

### Example of carrying out the invention

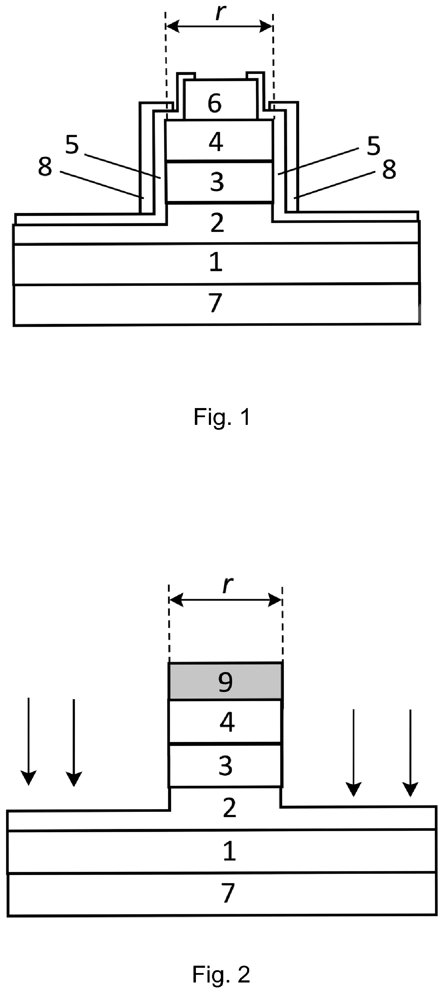

Figure 1 shows an enhancement-mode unipolar vertical GaN transistor comprising a conductive GaN substrate 1, a doped drift n GaN layer 2, a channel insulating GaN layer 3, a doped contacting *n*⁺ GaN layer 4, a dielectric insulating layer 5, a source electrode 6, a drain electrode 7 and a gate electrode 8. The characteristic distance between the vertical walls of the channel insulating GaN layer 3 and the width of the contacting *n*⁺ GaN layer 4 is denoted by *r*.

The GaN layers are epitaxially grown, for example by MBE or MOCVD, on a conductive GaN substrate whose surface has been prepared for epitaxial growth. In MBE, GaN is grown using nitrogen plasma or in an ammonia environment. In MOCVD, TMGa and NH₃ are used as growth precursors and silane is used as a source of silicon donors. The GaN substrate typically has a thickness of about 300 µm, a resistivity below 25 mΩ·cm, and an orientation providing subsequent growth along the c-axis. Before growth, contamination and adsorbed gaseous particles are removed from the GaN surface, for example by heating in the growth chamber to a temperature above 1000 °C.

The drift n GaN layer 2 is then grown and doped with silicon so that the free-electron concentration *n_{d}* and thickness *d_{d}* fulfil the inequalities *n_{d}* < 2 *V_{BR} ε*/(*q d_{d}*²) and *d_{d}* > *V_{BR}*/*E_{crit}*, where *V_{BR}* is the required drain breakdown voltage and *E_{crit}* ≈ 5 × 10⁶ V/cm is the electric breakdown field of GaN. For *V_{BR}* values from hundreds of volts to the kilovolt range, *n_{d}* is typically about 10¹⁶ cm⁻³ and at most about 2 × 10¹⁷ cm⁻³, while *d_{d}* is about 5 to 15 µm and at least about 3 µm. If the residual free-electron concentration is sufficiently high, silicon doping may be omitted.

The channel insulating GaN layer 3 is subsequently grown. Its thickness *L* is, for example, 1 to 3 µm, although a sub-micrometre thickness may be selected to increase switching speed. The contacting *n*⁺ GaN layer 4 is grown last. It may have a silicon doping concentration of about 10¹⁸ cm⁻³ and a thickness of about 0.2 to 1 µm.

The distance between the vertical walls of the channel insulating GaN layer 3 and, respectively, the contacting *n*⁺ GaN layer 4 is defined by etching mesa regions having the characteristic dimension *r*, as shown in Figure 2. Reactive ion etching (RIE) is performed through resist mask 9 using, for example, SiCl₄-based gases. If a circular geometry of the source electrode 6 is selected and the thickness of the dielectric insulating layer 5 is neglected (see Figure 1), the channel perimeter is *w* = 2π·*radius*, *w* = *π*·*diameter*, i.e. *w* = π*r*. For *r* ≈ 130 µm, *w* ≈ 400 µm. These dimensions can be defined using conventional optical lithography without electron-beam lithography or nano-patterning. The sufficiently large area of the source electrode 6 also facilitates direct contacting of the electrodes without a contact-pad lead extending beyond the mesa region. A rectangular geometry of the source electrode 6 may alternatively be selected with side lengths *w* and *r*. The mesa region is etched to a depth reaching the drift layer 2, for example about 1.5 to 4 µm depending on the actual layer thicknesses.

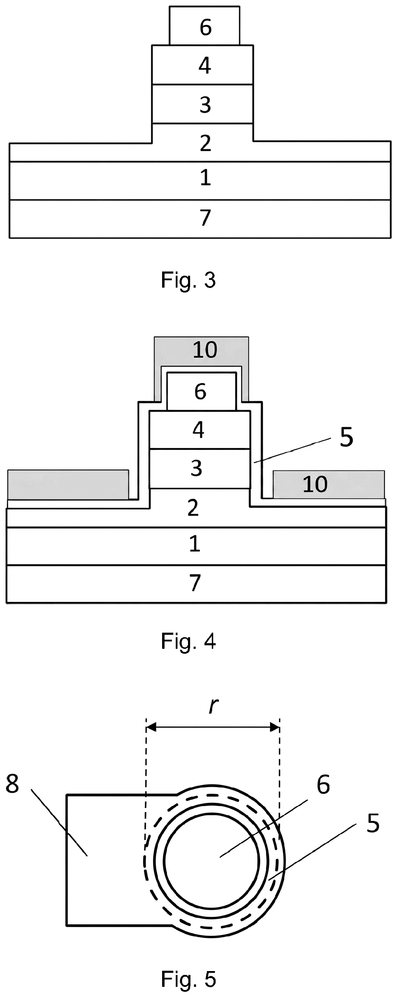

After etching, the source electrode 6 is formed using optical lithography, as shown in Figure 3. Its dimensions provide sufficient tolerance relative to the edge of the mesa region and to the edge of the subsequent resist mask 10 for the gate electrode, as shown in Figures 1, 3 and 4. An ohmic metallisation system, for example Ti/Al/Ni/Au, is evaporated and patterned by lift-off, followed by a short thermal anneal at about 850 °C.

The dielectric insulating layer 5, for example Al₂O₃, ZrO₂ or HfO₂ having a thickness of about 5 to 20 nm, is then grown before formation of resist mask 10. The layer may be deposited over the entire device by conformal atomic layer deposition (ALD). The dielectric insulating layer 5 has a wider energy band gap than GaN and suppresses gate leakage currents even under a positive gate bias *V_{G}*.

After formation of resist mask 10 shown in Figure 4, metal is deposited on the vertical walls of the channel insulating GaN layer 3 with some overlap onto the adjacent drift n GaN layer 2 and contacting *n*⁺ GaN layer 4. Metals such as nickel and gold, or conductive oxides, may be deposited by sputtering, angled electron-beam evaporation, electroplating or ALD. Contact pads for the gate electrode 8 may be led outside the defined mesa region, as shown in Figure 5. After formation of the bottom drain electrode 7, further contact metallisation may be deposited on selected areas of all electrodes and the device may be passivated, for example by a protective Si₃N₄ layer.

### Example 1

In the first example, residual donors in the channel insulating GaN layer 3 are compensated by adding or increasing the concentration of carbon. In MBE, carbon may be supplied from an external source, for example an ion gun. In MOCVD, an external organic carbon precursor may be used, although this is not necessarily required because carbon is inherently present in organometallic GaN growth precursors such as TMGa.

The MOCVD parameters are set so that the carbon concentration exceeds conventional residual carbon levels in unintentionally doped n GaN layers. For example, the growth temperature may be reduced by more than 100 °C from the optimum GaN growth temperature, such as from 1080 °C to 900 °C, and/or the pressure may be reduced by a factor of several. The NH₃ flow may be reduced or the TMGa flow increased. N₂, H₂ or a mixture thereof may be used as carrier gas, and the carbon concentration may be increased by increasing the H₂ flow. In this manner, the carbon concentration may be increased from a residual unintentionally present level, for example from 10¹⁶ cm⁻³ up to 10¹⁸ cm⁻³.

### Example 2

In the second example, residual donors in the channel insulating GaN layer 3 are compensated by adding iron. Iron may be supplied from an external source or from a precursor.

### Example 3

In the third example, residual donors in the channel insulating GaN layer 3 are compensated by adding magnesium. Magnesium may be supplied from an external source or from a precursor.

### Example 4

In the fourth example, residual donors in the channel insulating GaN layer 3 are compensated by increasing the concentration of gallium vacancies. The concentration of these defects may be increased, for example, by increasing the V/III molar ratio during growth.

The following description of transistor operation is based on the analytical model described by K. Lee et al., IEEE Transactions on Electron Devices, vol. ED-30, pp. 207-212 (1983), and W. R. Curtice, IEEE Transactions on Microwave Theory and Techniques, vol. 28, p. 448 (1980), modified for calculation of current in a MOSFET having the channel insulating GaN layer 3. The threshold voltage is: ${V}_{T} = {Φ}_{Box} - Δ {E}_{C}$ (1) where *Φ_{Box}* is the Schottky barrier height of the metal gate electrode 8 on the oxide or dielectric insulating layer 5, and *ΔE_{C}* is the band discontinuity at the oxide/GaN interface. The saturation current between the source electrode 6 and drain electrode 7 is: ${I}_{sat} = \frac{{βV}_{s}^{2} {\left(1+2{βR}_{S}V{′}_{G}+V{{′}_{G}}^{2}/{V}_{s}^{2}\right)}^{1 / 2} - \left(1+{βR}_{S}V{′}_{G}\right)}{1 - {β}^{2} {R}_{S}^{2} {V}_{s}^{2}}$ (2) where *R_{S}* is the parasitic resistance of the source region, and: $V {′}_{G} = {V}_{G} - {V}_{T}$ (3) ${V}_{s} = \frac{{ν}_{s} L}{μ}$ (4) $β = \frac{εμw}{{d}_{EOT} L}$ (5) where L is the channel length, equal to the thickness of the channel insulating GaN layer 3; *ε* is the permittivity of the channel insulating GaN layer 3; *d_{EOT}* is the equivalent thickness of the dielectric insulating layer 5 relative to *ε*; and *w* is the width or perimeter of the channel in the third dimension perpendicular to the illustrated cross-section. The dependence of drain current *I_{DS}* on drain voltage *V_{DS}* is calculated using the heuristic relationship: ${I}_{DS} = {I}_{sat} \left(1+{λV}_{DS}\right) tanh \left({ηV}_{DS}\right)$ (6) where *η* is calculated as: $η = \frac{{qμn}_{si} / L}{{I}_{sat} \left[1+\left({R}_{S}+{R}_{D}\right)\left({qμn}_{si}/L\right)\right]}$ (7) and: ${n}_{si} = \frac{ε \left({V}_{G}-{I}_{sat}{R}_{S}-{V}_{T}\right)}{{qd}_{EOT}}$ (8) where q is the electron charge, *R_{D}* is the parasitic resistance of the drain region, and *λ* is an output-conductance parameter. Self-heating effects are not included in the model.

Calculation of the output currents is combined with calculation of the energy-band structure by solving the Poisson-Schrödinger equation according to I. H. Tan et al., Journal of Applied Physics, vol. 68, p. 4071 (1990).

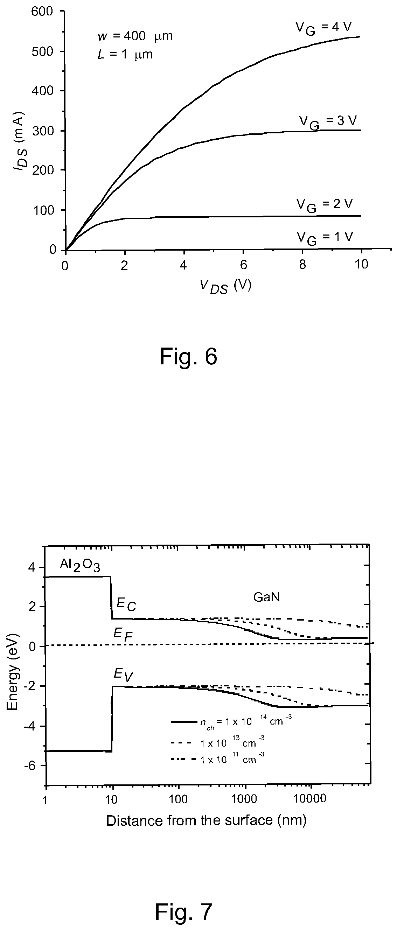

Figure 6 shows simulated output characteristics of the enhancement-mode transistor of Figure 1. The calculation assumes *L* = 1 µm, *w* = 400 µm, *R_{S}* = 1 Ω, *R_{D}* = 10 Ω and *µ* = 1000 cm²/Vs. The higher value of *R_{D}* reflects the requirement for a higher breakdown voltage in the range of hundreds of volts to kilovolts, which defines the upper limit of the free-carrier concentration and a minimum thickness of the drift n GaN layer 2. A 10 nm thick dielectric insulating layer 5 based on Al₂O₃ is considered, with a relative permittivity of 9, *Φ_{Box}* = 3.2 eV and *ΔE_{C}* = 2 eV. Currents of about 550 mA at *V_{G}* = 4 V indicate suitability for power applications. The insulating character of the channel insulating GaN layer 3 also enables a robust construction of the upper source electrode 6 without reducing the threshold voltage *V_{T}.*

Figure 7 shows the energy-band diagram in the transistor channel along the distance *r* from the surface of the dielectric insulating layer 5. The calculation is shown for various concentrations *n_{ch}* of free electrons in the channel, considering depletion from one side only. For *n_{ch} =* 1 × 10¹⁴ cm⁻³, bending of the band diagram begins at a distance of about 200 nm from the surface and the full shift of the conduction band towards the Fermi level occurs at a distance below 3 µm. For an unintentionally doped n GaN layer having a residual electron concentration of 10¹⁵ to 10¹⁶ cm⁻³, *r <* 1 µm is required to obtain a positive threshold voltage and low leakage currents.

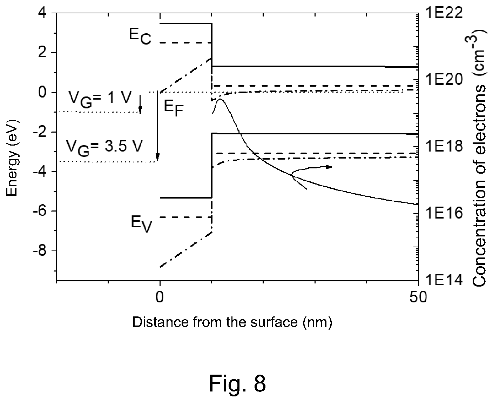

For a carbon-doped channel insulating GaN layer 3 having *n_{ch} =* 1 × 10¹¹ cm⁻³, the conduction-band shift occurs only for *r >* 70 µm. Such a value of *n_{ch}* can be obtained only by intentional acceptor doping and compensation of residual donors. Figure 8 illustrates enhancement-mode operation by showing the energy-band diagram and generation of free electrons in the channel insulating GaN layer 3 under positive gate bias *V_{G}.* At *V_{G}* = 1 V, below *V_{T},* the bands are shifted vertically without generating free carriers. At *V_{G}* = 3.5 V, a conductive channel having *n_{ch} >* 2 × 10¹⁹ cm⁻³ is formed, with an integrated sheet concentration of about 9 × 10¹⁶ m⁻².

The vertical GaN transistor of Figure 1 therefore enables a robust geometry with *r* ≈ 130 µm without complex nanotechnology and provides enhancement-mode operation.

### Industrial applicability

Power enhancement-mode transistors having an insulating GaN channel layer can be used in highly efficient electrical-power converters, in the generation and distribution of electrical energy, and in charging and propulsion units of electric vehicles.

## Claims

1. A vertical GaN transistor with an insulating channel layer, comprising, from the bottom upwards, at least:
(a) a conductive GaN substrate (1);
(b) a drift n GaN layer (2) formed on the conductive GaN substrate (1);
(c) a channel insulating GaN layer (3) formed on the drift n GaN layer (2), wherein residual donors are compensated by adding or increasing a concentration of carbon (C), and wherein the concentration of carbon impurities in the channel insulating GaN layer (3) is in the range of 10¹⁶ cm⁻³ to 10¹⁸ cm⁻³; and
(d) a contacting *n*⁺ GaN layer (4) formed on the channel insulating GaN layer (3);
wherein a source electrode (6) is located on top of the contacting *n*⁺ GaN layer (4), a drain electrode (7) is located at the backside of the conductive GaN substrate (1), and a gate electrode (8) is located vertically along the channel insulating GaN layer (3) and is separated along its whole length from the contacting *n*⁺ GaN layer (4), the channel insulating GaN layer (3) and the drift n GaN layer (2) by a dielectric insulating layer (5) having a wider energy band gap than GaN.

2. The vertical GaN transistor according to claim 1, wherein the concentration of free electrons in the channel insulating GaN layer (3) is less than or equal to 10¹¹ cm⁻³.

3. The vertical GaN transistor according to claim 1 or 2, wherein the source electrode (6) has a rectangular geometry.

4. A method of forming a vertical GaN transistor with an insulating channel layer, the method comprising sequentially at least:
(a) growing a drift n GaN layer (2) on a conductive GaN substrate (1);
(b) growing a channel insulating GaN layer (3) after forming the drift n GaN layer (2), wherein residual donors are compensated by adding or increasing a concentration of carbon (C), and wherein the concentration of carbon impurities in the channel insulating GaN layer (3) is in the range of 10¹⁶ cm⁻³ to 10¹⁸ cm⁻³;
(c) growing a contacting *n*⁺ GaN layer (4) after forming the channel insulating GaN layer (3); and
(d) subsequently forming a source electrode (6) on top of the contacting *n*⁺ GaN layer (4), a drain electrode (7) at the backside of the conductive GaN substrate (1), and a gate electrode (8) vertically along the channel insulating GaN layer (3), the gate electrode (8) being separated along its whole length from the contacting *n*⁺ GaN layer (4), the channel insulating GaN layer (3) and the drift n GaN layer (2) by a dielectric insulating layer (5) having a wider energy band gap than GaN.

5. The method according to claim 4, wherein the residual donors are compensated so that the concentration of free electrons in the channel insulating GaN layer (3) is less than or equal to 10¹¹ cm⁻³.

6. The method according to claim 4 or 5, wherein the source electrode (6) is formed with a rectangular geometry having side lengths *w* and *r*.
